# EUROPEAN PATENT APPLICATION

(11) **EP 3 585 137 A1**
(43) Date of publication of application: **25.12.2019**
(21) Application number: 17899686.4
(22) Date of filing: 05.06.2017
(51) Int. Cl.: H05K 1/14

(54) **MOTHERBOARD AND TERMINAL FOR USE WITH CONSUMER ELECTRONIC PRODUCTS**

(30) Priority: 09.03.2017 CN 201710138321
(71) Applicant: Huawei Technologies Co., Ltd., Longgang District Shenzhen, Guangdong 518129 (CN)
(72) Inventor: WANG, Yong, Shenzhen Guangdong 518129 (CN); QIAO, Jitao, Shenzhen Guangdong 518129 (CN); SUN, Rui, Shenzhen Guangdong 518129 (CN); ZHU, Fujian, Shenzhen Guangdong 518129 (CN); DING, Haixing, Shenzhen Guangdong 518129 (CN)
(74) Representative: Epping - Hermann - Fischer
(86) International application number: PCT/CN2017/087166
(87) International publication number: WO 2018/161450

(57) **Abstract**

Embodiments of the present invention provide a mainboard for a consumer electronic product, and a terminal. The mainboard includes at least two layers of PCBs and electronic components disposed on each layer of PCB of the at least two layers of PCBs, where each layer of PCB constitutes a unit module. The at least two layers of PCBs are stacked, and the at least two layers of PCBs are electrically connected. Any two adjacent unit modules are connected by using a frame board, and the frame board has a middle-hollow or partially hollow structure. The mainboard is designed into a multilayer composite stacked structure, to reduce an area occupied by the mainboard in horizontal directions and provide plane space for electronic parts such as a display module, a camera module, a speaker box component. In addition, functional regions on the mainboard or a sub-board, for example, a baseband circuit part and a radio frequency circuit part, are divided into a plurality of independent baseband circuit unit modules and radio frequency circuit unit modules, facilitating arrangement of wire connections between the electronic components. Therefore, an integration level of the electronic components is improved, and the area occupied by the mainboard in the horizontal directions is further reduced.

## Description

This application claims priority to Chinese Patent Application No. 201710135105.1, filed with the State Intellectual Property Office of China on March 8, 2017 and entitled "STACKED STRUCTURE OF RIGID MAINBOARD PCB FOR ELECTRONIC PRODUCT", which is incorporated herein by reference in its entirety.

### TECHNICAL FIELD

The present invention relates to the field of electronic boards, and in particular, to a mainboard for a consumer electronic product, and a terminal.

### BACKGROUND

Consumer electronic products refer to electronic products used by consumers in daily lives, and include mobile phones, tablet computers, notebook computers, intelligent wearable devices, and the like. A consumer electronic product needs a mainboard and a sub-board to carry all electronic components, for example, to connect electronic parts such as a display module, a camera module, a speaker box component, a battery, and an antenna. Currently, for a consumer electronic product, a planar integrated structure is used in both its mainboard and sub-board. To be specific, one mainboard printed circuit board (Printed Circuit Board, PCB) or a combination of one mainboard PCB and one or more sub-board PCBs is used, where all electronic components are disposed on one or both sides of the mainboard PCB and the sub-board PCB. The mainboard generally carries core chip components such as a processor, a memory, a radio frequency component, and the sub-board carries interface components such as an earphone, a motor, a data transmission and charging interface connector, and a power button.

As audio and video entertainment functions of consumer electronic products are increasingly diversified, space required for accommodation of a display module, a camera module, a speaker box component, and the like is becoming increasingly large. In addition, because consumer electronic products are used more frequently, larger capacity batteries need to be built into the consumer electronic products to implement a long standby time. In addition, many consumer electronic products have integrated functions, such as 4th-generation mobile communications technology (4th-Generation mobile communications technology, 4G) communication, a Wireless Fidelity (Wireless-Fidelity, Wi-Fi) technology, a Global Positioning System (Global Positioning System, GPS), and Bluetooth. Therefore, a larger quantity of more complex antennas need to be arranged inside the consumer electronic product, and enough space needs to be provided to avoid mutual interference between different antennas. All this shows that audio/video components, batteries, and antennas are demanding increasingly large internal space in consumer electronic products. However, to maintain or improve portability and comfort of use of the consumer electronic products, a total size of a consumer electronic product needs to be maintained or even reduced. As a result, a plane area that can be occupied by a mainboard or a sub-board of a consumer electronic product is becoming smaller, making it difficult to meet the demand of electronic components for larger space.

### SUMMARY

Embodiments of the present invention provide a mainboard for a consumer electronic product, and a terminal, to resolve a problem of insufficient space for accommodation of electronic components. According to the embodiments of the present invention, a mainboard is designed into a multilayer composite stacked structure, to reduce an area occupied by the mainboard in horizontal directions and provide plane space for electronic parts such as a display module, a camera module, a speaker box component, a battery, and an antenna.

According to a first aspect, an embodiment of the present invention provides a mainboard for a consumer electronic product. The mainboard includes at least two layers of PCBs and electronic components disposed on each layer of PCB of the at least two layers of PCBs, where each layer of PCB constitutes a unit module. The at least two layers of PCBs are stacked, and the at least two layers of PCBs are electrically connected. The mainboard is designed into a multilayer composite stacked structure, to reduce an area occupied by the mainboard in horizontal directions and provide plane space for electronic parts such as a display module, a camera module, a speaker box component, a battery, and an antenna. Functional regions on the mainboard or a sub-board, for example, a baseband circuit part and a radio frequency circuit part, are divided into a plurality of independent baseband circuit unit modules and radio frequency circuit unit modules, facilitating arrangement of wire connections between the electronic components. Therefore, an integration level of the electronic components is improved, and the area occupied by the mainboard in the horizontal directions is further reduced.

In a possible design, any two adjacent unit modules are connected by using a frame board.

In a possible design, the frame board is a middle-hollow or partially hollow structure. By designing the frame board into the middle-hollow or partially hollow structure, an upper surface and a lower surface of the unit module connected to the frame board can both carry electronic components, so that more electronic components can be integrated into the unit module, thereby improving space utilization.

In a possible design, a cross-section of the frame-board has a strip shape, an annular shape, a C-shape, a shape like the Chinese character " 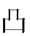 ", a shape like the Chinese character " 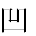 ", a shape like the Chinese character " 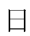 ", or a shape like the Chinese character " 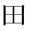 ". Shapes of the unit module and the frame board are flexibly designed to match shapes of an outline and internal space of the consumer electronic product, for example, designed into a circle, a rectangle, or an irregular shape, to make full use of the internal space of the consumer electronic product, thereby improving space utilization.

In a possible design, the frame board is connected to the PCBs by using bonding pads. The unit modules are connected to each other by using one or more frame boards. The unit modules are connected together by using corresponding bonding pads on the upper and lower surfaces of the frame board, to implement an entire functional circuit of the consumer electronic product. A shape of the connecting bonding pad between the unit module and the frame board may be flexibly designed into a circle, a rhombus, or a square as required. The unit modules and the frame board can be stacked and connected three-dimensionally in a Z direction through solder paste soldering, conductive adhesive bonding, or metal dome contacting.

In a possible design, a metal dome is disposed on a surface of the bonding pad of the frame board.

In a possible design, screw holes are made into connecting interfaces of the frame board and the unit module. By designing screw holes at four corners of the unit module and the frame board, a bonding pad connection between the unit module and the frame board can be further locked and fastened by using the screw holes.

In a possible design, the frame board is a PCB board.

In a possible design, each layer of PCB is a system in a package SIP module. The unit module is designed into a SIP module, with a thin and high-density package substrate or substrate-like PCB used to implement the unit module, in combination with a packaging technology such as wire bonding (Wire Bonding) or flip chip (Flip Chip) packaging, to integrate more electronic components into the unit module and reduce a thickness of the unit module. Therefore, a total size of the mainboard is reduced, and space utilization is improved.

According to a second aspect, an embodiment of the present invention provides a terminal. The terminal may include any mainboard in the foregoing first aspect.

Compared with the prior art, the mainboard for a consumer electronic product provided in the embodiments of the present invention has the following advantages: 1. The mainboard is designed into a multilayer composite stacked structure, to reduce an area occupied by the mainboard in horizontal directions and provide plane space for electronic parts such as a display module, a camera module, a speaker box component, a battery, and an antenna. 2. The functional regions on the mainboard or the sub-board, for example, the baseband circuit part and the radio frequency circuit part, are divided into a plurality of independent baseband circuit unit modules and radio frequency circuit unit modules, facilitating arrangement of wire connections between the electronic components. Therefore, an integration level of the electronic components is improved, and the area occupied by the mainboard in the horizontal directions is further reduced. 3. The unit module is designed into a SIP module, with a thin and high-density package substrate or substrate-like PCB used to implement the unit module, in combination with a packaging technology such as wire bonding (Wire Bonding) or flip chip (Flip Chip) packaging, to integrate more electronic components into the unit module and reduce a thickness of the unit module. Therefore, a total size of the mainboard is reduced, and space utilization is improved. 4. The unit modules are connected to each other by using one or more frame boards. The unit modules are connected together by using corresponding bonding pads on the upper and lower surfaces of the frame board, to implement an entire functional circuit of the consumer electronic product. A shape of the connecting bonding pad between the unit module and the frame board may be flexibly designed into a circle, a rhombus, or a square as required. The unit modules and the frame board can be stacked and connected three-dimensionally in a Z direction through solder paste soldering, conductive adhesive bonding, or metal dome contacting. 5. By designing screw holes at four corners of the unit module and the frame board, a bonding pad connection between the unit module and the frame board can be further locked and fastened by using the screw holes. 6. By designing the frame board into the middle-hollow or partially hollow structure, an upper surface and a lower surface of the unit module connected to the frame board can both carry electronic components, so that more electronic components can be integrated into the unit module, thereby improving space utilization. 7. Shapes of the unit module and the frame board are flexibly designed to match shapes of an outline and internal space of the consumer electronic product, for example, designed into a circle, a rectangle, or an irregular shape (such as an L-shape, a C-shape, a shape like the Chinese character " 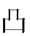 " or a shape like the Chinese character " 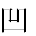 "), to make full use of the internal space of the consumer electronic product, thereby improving space utilization.

### BRIEF DESCRIPTION OF DRAWINGS

FIG. 1(a) and FIG. 1(b) are schematic diagrams of cross-sections of a PCBA in the prior art;
FIG. 2(a) and FIG. 2(b) are schematic diagrams of cross-sections of a mainboard according to an embodiment of the present invention;
FIG. 3(a) to FIG. 3(c) are schematic diagrams of applications of a mainboard according to an embodiment of the present invention;
FIG. 4 is a schematic diagram of a cross-section of a frame board having a shape like the Chinese character " 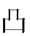 " according to an embodiment of the present invention;
FIG. 5(a) to FIG. 5(d) are schematic diagrams of cross-sections of a bonding pad according to an embodiment of the present invention; and
FIG. 6(a) to FIG. 6(d) are schematic diagrams illustrating how a frame board and a unit module are connected through metal dome contacting according to an embodiment of the present invention.

### DESCRIPTION OF EMBODIMENTS

The following describes the technical solutions in the embodiments of the present invention with reference to the accompanying drawings in the embodiments of the present invention.

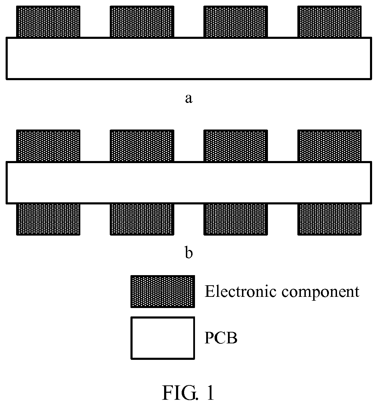

FIG. 1(a) and FIG. 1(b) are schematic diagrams of cross-sections of a PCBA in the prior art. As shown in FIG. 1, currently, planar design is used for both a mainboard printed circuit board assembly (Printed Circuit Board Assembly, PCBA) and a sub-board PCBA of a consumer electronic product. To be specific, electronic components are soldered onto PCB surfaces by using a soldering material such as a solder paste on one or both sides of a mainboard PCB and a sub-board PCB. Because the PCBA has a single-layer arrangement, the mainboard or sub-board occupies a relatively large plane area in longitudinal and latitudinal directions.

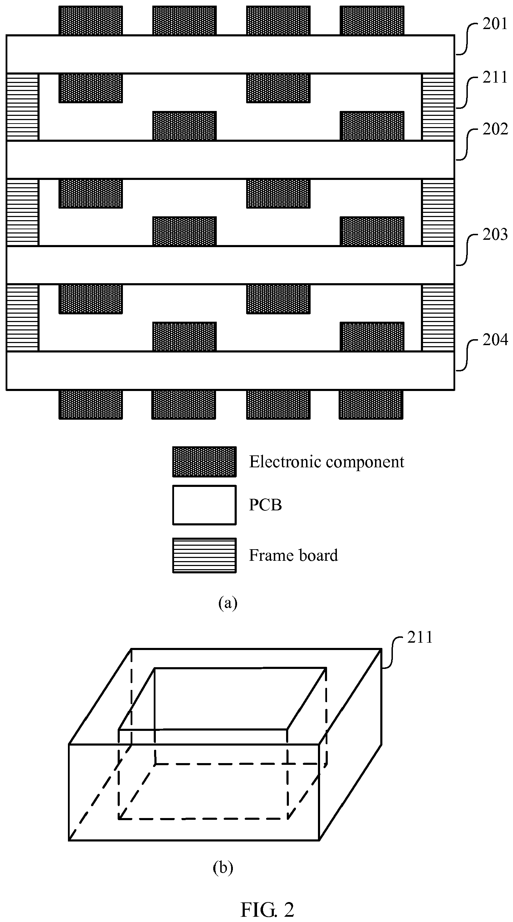

FIG. 2(a) and FIG. 2(b) are schematic diagrams of cross-sections of a mainboard according to an embodiment of the present invention. As shown in FIG. 2(a), the mainboard includes at least two layers of PCBs and electronic components disposed on the at least two layers of PCBs (for example, the electronic components are soldered on a surface of each layer of PCB by using a solder paste). The at least two layers of PCBs are stacked, and the at least two layers of PCBs are electrically connected. In FIG. 2(a), a total of four layers of PCBs, a PCB 201, a PCB 202, a PCB 203, and a PCB 204, are used as an example. The mainboard provided in this embodiment of the present invention makes use of space in a Z direction, thereby alleviating a problem that single-layer planar design causes occupation of a large plane area in horizontal directions of X and Y and results in low space utilization. It should be noted that, the structure and other design, provided in this embodiment of the present invention, for the mainboard is also applicable to sub-boards or other electronic boards of consumer electronic products.

For example, each layer of PCB of the mainboard and electronic components disposed on this layer of PCB constitute a unit module. The unit module can implement specific functions independently and is a smallest functional unit into which the mainboard can be divided. Each unit module or several adjacent unit modules constitute a functional region. For example, the mainboard includes a baseband circuit functional region. The region consists of a baseband circuit unit module, for example, the PCB 201. The PCB 201 integrates electronic components such as a mobile phone main processor chip (or referred to as a central processing unit (Central Processing Unit, CPU) or an application processor), an in-memory chip of a dual data rate (Dual Data Rate, DDR) synchronous dynamic random access memory (Synchronous Dynamic Random Access Memory, SDRAM) or random access memory (Random Access Memory, RAM), a storage chip of a NAND flash memory (Nand Flash) or a read only memory (Read Only Memory, ROM), an audio/video control chip, and peripheral resistors, capacitors, and inductors. The baseband circuit functional region is used to complete demodulation, descrambling, dispreading, and decoding on a wireless signal in a mobile network, and transmit a final decoded digital signal to an upper-layer system for processing. For another example, the mainboard includes a radio frequency circuit functional region. The region consists of a first radio frequency circuit unit module PCB 202 and a second radio frequency circuit unit module PCB 203. The first radio frequency circuit unit module integrates electronic components such as a mobile phone radio frequency receive chip and transmit chip, a power amplifier, and peripheral resistors, capacitors, and inductors, to implement long-distance communication functions. The second radio frequency circuit unit module integrates electronic components such as a Wireless-Fidelity (Wireless-Fidelity, Wi-Fi) chip, a Bluetooth chip, a global positioning system (Global Positioning System, GPS) chip, and peripheral resistors, capacitors, and inductors, to implement short-distance communication functions. The radio frequency circuit functional region consisting of the first radio frequency circuit unit module and the second radio frequency circuit unit module is used to implement total communication functions.

Because the mainboard is formed by stacking a plurality of layers of PCBs, an area occupied by the mainboard in the horizontal directions can be reduced. In addition, the mainboard is divided into a plurality of functional regions, and each functional region includes one or more unit modules, facilitating arrangement of wire connections between the electronic components. In this way, an integration level of the electronic components is improved, and the area occupied by the mainboard in the horizontal directions is further reduced.

For example, any two adjacent unit modules are connected together by using one or more frame boards. The frame board has a middle-hollow or partially hollow structure, and a plurality of unit modules are stacked and connected by using the frame board to constitute an entire functional circuit of the consumer electronic product. The frame board may be a PCB board, or other circuit boards having an electrical connection function. For example, as shown in FIG. 2(b), the PCB 201 and the PCB 202 are connected together by using a middle-hollow frame board 211. It should be noted that the entire functional circuit is a complete circuit of an instrument or a device. In this embodiment of the present invention, the entire functional circuit is a complete circuit of the consumer electronic product. The frame board is configured to connect adjacent unit modules electrically, so that an electrical functional connection can be implemented between a plurality of unit modules. In addition, the mainboard can form a stacked structure of PCBs, to implement space utilization in the Z direction.

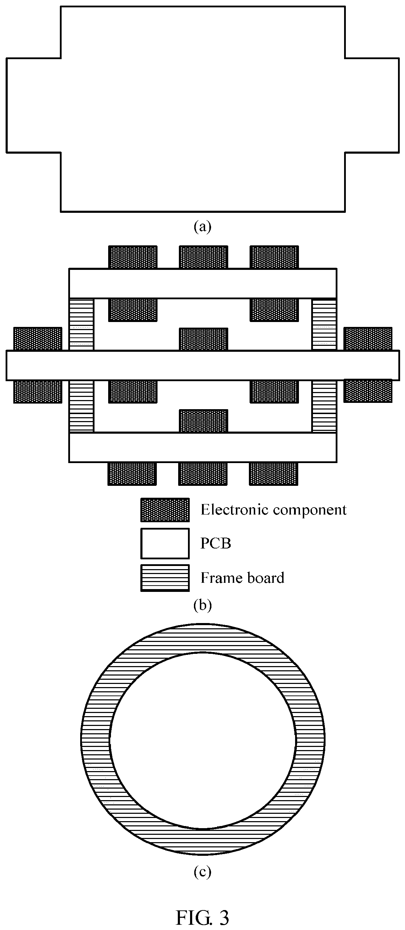

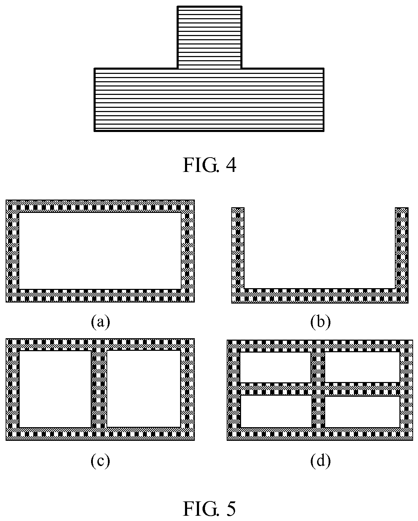

For example, the unit module and the frame board may match an outline and internal space of the consumer electronic product. Each layer of PCB and the frame board are flexibly designed into an annular shape, a shape like the Chinese character " 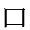 ", an L-shape, a C-shape, a shape like the Chinese character " 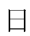 ", a shape like the Chinese character " 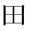 ", a shape like the Chinese character " 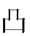 ", a shape like the Chinese character " 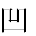 ", or the like, and corresponding electronic components are disposed on each layer of PCB. For example, internal space of an electronic smartwatch shown in FIG. 3(a) is constituted by stacking cylinders with different diameters, and to make full use of the internal space, as shown in FIG. 3(b), each layer of PCB and the frame board are designed into circles of corresponding sizes. The frame board is a middle-hollow cylinder, as shown in FIG. 3(c), a cross-section of the frame board has an annular shape. For another example, when internal space of a consumer electronic product is a structure having a shape like the Chinese character " 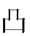 ", to make full use of the internal space, each layer of PCB and the frame board are correspondingly designed into structures with a cross-section having a shape like the Chinese character " 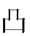 ". As shown in FIG. 4, the cross-section of the frame board has a shape like the Chinese character " 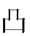 ". For another example, to reduce space occupied by the mainboard, a system in a package (System In a Package, SIP) design is used for the unit module, so that the unit module and frame board can more flexibly match internal space of an electronic product. To be specific, each layer of PCB uses a thin and high-density package substrate or substrate-like PCB, in combination with a packaging technology such as wire bonding (Wire Bonding) or flip chip (Flip Chip) packaging, to integrate more electronic components on each layer of PCB. In this manner, a thickness of each layer of PCB can be reduced and an integration level of the electronic components on the unit module can be improved. Therefore, a total size of the mainboard is reduced, and space utilization is improved.

It should be noted that, wire bonding is a processing technology in which fine metal wires are used and heat, pressure, and ultrasonic energy are utilized to make metal leads closely soldered to bonding pads of the substrate, to implement electrical interconnection between chips and the substrate and information interworking between chips. Under an ideal control condition, electron sharing or atomic mutual diffusion occurs between the leads and the substrate, so that the two metals are atomically bonded. A purpose of the wire bonding is to lead an electrical connection into or out of a core component. The flip chip packaging technology, however, uses a flip chip to adjoin and package a first layer of chip to the substrate. The packaging manner is that the chip faces the substrate downward without wire bonding, thereby forming a shortest circuit and reducing resistances. In addition, by using metal ball connection, a package size is reduced, and electrical performance is improved.

For example, a connection manner between the unit module and the frame board may be a solder paste soldering manner, a conductive adhesive bonding manner, or a metal dome contacting manner. To use these three connection manners, bonding pads need to be disposed at connecting interfaces of the unit module and the frame board (both the unit module and the frame board need to be provided with a bonding pad). A shape of the bonding pad may be designed in accordance with a shape of the connecting interface. For example, when the shape of the connecting interface is a shape like the Chinese character " 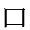 ", the shape of the bonding pad is correspondingly a shape like the Chinese character " 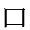 ", as shown in FIG. 5(a). For another example, when the shape of the connecting interface is a C-shape, the shape of the bonding pad is correspondingly a C-shape, as shown in FIG. 5(b). For still another example, when the shape of the connecting interface is a shape like the Chinese character " 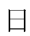 ", the shape of the bonding pad is correspondingly a shape like the Chinese character " 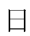 ", as shown in FIG. 5(c). For yet another example, when the shape of the connecting interface is a shape like the Chinese character " 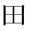 ", the shape of the bonding pad is correspondingly a shape like the Chinese character " 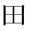 ", as shown in FIG. 5(d).

A process of connecting the unit module to the frame board in a solder paste soldering manner includes: applying a solder paste in advance in a printing manner (Printing) or a jetting manner (Jetting) or a dispensing manner (Dispensing) on a bonding pad that is on a surface of the frame board, then using an automatic mounting device to pick up the unit module and place the unit module to a position of the bonding pad on the surface of the frame board, and adjoining the unit module and frame board through soldering with molten solder paste in a high-temperature reflow manner or a hot bar (Hot Bar) or similar hot-press manner. A principle of hot bar soldering (Hot Bar) is first printing solder paste on a PCB and then using heat to melt soldering tin to electrically adjoin two electronic components that need to be connected.

A process of connecting the unit module to the frame board using conductive adhesive bonding includes: applying conductive adhesive in advance in a printing manner (Printing) or a jetting manner (Jetting) or a dispensing manner (Dispensing) on a bonding pad that is on a surface of the frame board, then using an automatic mounting device to pick up the unit module and place the unit module to a position of the bonding pad on the surface of the frame board, and adjoining the unit module and the frame board securely in a high-temperature reflow manner by applying a high temperature to the conductive adhesive.

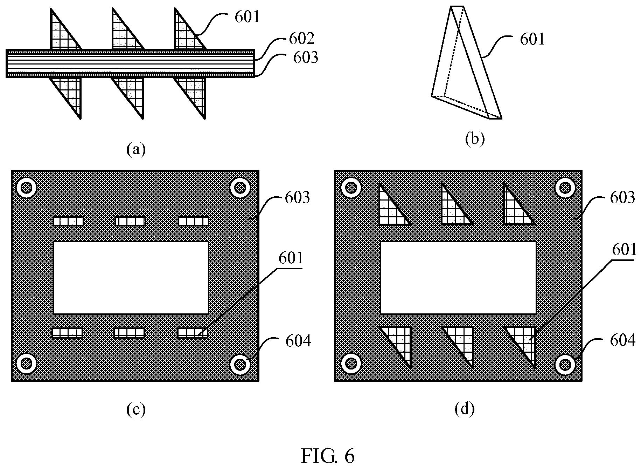

A process of connecting the unit module to the frame board through metal dome contacting includes: applying electroless nickel/immersion gold (Electroless Nickel/Immersion Gold, ENIG) to or performing other low-contact resistance conductive surface treatment on a bonding pad on a surface of the frame board, and forming a raised metal dome on the surface of the bonding pad of the frame board through hot-pressing or spot soldering; then using an automatic mounting device to pick up the unit module and mount the unit module to a position of the bonding pad on the surface of the frame board; and establishing a conductive connection between the unit module and the metal dome on the surface of the frame board through locking and fastening by using screws. For example, as shown in FIG. 6(a), a metal dome 601 is disposed on a surface of a bonding pad 603 of a frame board 602. A shape of the metal dome 601 is a triangular sheet shape shown in FIG. 6(b). As shown in FIG. 6(c), screw holes are made at four corners of the bonding pad 603 of the frame board. The screw holes are through holes that pass through the frame board 602 and the bonding pad 603. Before the automatic mounting device picks up the unit module paste and mounts the unit module to the position of the bonding pad on the surface of the frame board, a top view of the metal dome 601 is shown in FIG. 6(c), and after the automatic mounting device picks up the unit module and mounts the unit module to the position of the bonding pad on the surface of the frame board, the metal dome 601 is held down, and a top view of the metal dome 601 is shown in FIG. 6(d). It should be noted that, ENIG is one of PCB surface treatment technologies, and is used to prevent copper on a surface of the PCB from being oxidized or corroded, soldered, and the like.

Using the foregoing three connection manners can all establish an electric connection between the unit module and the frame board, and the unit module and the frame board that are connected together constitute the entire functional circuit of the consumer electronic product. By using solder paste soldering or conductive adhesive bonding, a permanent connection can be established between the unit module and the frame board. However, a connection established using metal dome contacting is a detachable connection, facilitating replacement of the frame board or the unit module. In addition, screw locking and fastening may be used to firm a connection between the unit module and the frame board, in, for example, not only the metal dome contacting manner but also other manners such as solder paste soldering and conductive adhesive bonding. This is not limited in the present invention.

The PCB provided in the embodiments of the present invention may be applied to terminals (for example, smartwatches, tablet computers, and mobile phones). When the terminal includes a PCB, the PCB may use a structure provided in any one of the embodiments of the present invention.

The technical solutions of the embodiments of the present invention provide the following several benefits:
1. The mainboard is designed into a multilayer composite stacked structure, to reduce an area occupied by the mainboard in horizontal directions and provide plane space for electronic parts such as a display module, a camera module, a speaker box component, a battery, and an antenna.
2. The functional regions on the mainboard or the sub-board, for example, the baseband circuit part and the radio frequency circuit part, are divided into a plurality of independent baseband circuit unit modules and radio frequency circuit unit modules, facilitating arrangement of wire connections between the electronic components. Therefore, an integration level of the electronic components is improved, and the area occupied by the mainboard in the horizontal directions is further reduced.
3. The unit module is designed into a SIP module, with a thin and high-density package substrate or substrate-like PCB used to implement the unit module, in combination with a packaging technology such as wire bonding (Wire Bonding) or flip chip (Flip Chip) packaging, to integrate more electronic components into the unit module and reduce a thickness of the unit module. Therefore, a total size of the mainboard is reduced, and space utilization is improved.
4. The unit modules are connected to each other by using one or more frame boards. The unit modules are connected together by using corresponding bonding pads on the upper and lower surfaces of the frame board, to implement an entire functional circuit of the consumer electronic product. A shape of the connecting bonding pad between the unit module and the frame board may be flexibly designed into a circle, a rhombus or a square as required. The unit modules and the frame board can be stacked and connected three-dimensionally in a Z direction through solder paste soldering, conductive adhesive bonding, or metal dome contacting.
5. By designing screw holes at four corners of the unit module and the frame board, a bonding pad connection between the unit module and the frame board can be further locked and fastened by using the screw holes.
6. By designing the frame board into the middle-hollow or partially hollow structure, an upper surface and a lower surface of the unit module connected to the frame board can both carry electronic components, so that more electronic components can be integrated into the unit module, thereby improving space utilization.
7. Shapes of the unit module and the frame board are flexibly designed to match shapes of an outline and internal space of the consumer electronic product, for example, designed into an annular shape, a shape like the Chinese character " 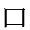 ", an L-shape, a C-shape, a shape like the Chinese character " 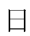 ", a shape like the Chinese character " 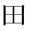 ", a shape like the Chinese character " 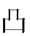 ", or a shape like the Chinese character " 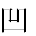 ", to make full use of the internal space of the consumer electronic product, thereby improving space utilization.

In the foregoing specific implementations, the objective, technical solutions, and benefits of the present invention are further described in detail. It should be understood that the foregoing descriptions are merely specific implementations of the present invention, but are not intended to limit the protection scope of the present invention. Any modification, equivalent replacement, or improvement made without departing from the spirit and principle of the present invention should fall within the protection scope of the present invention.

## Claims

1. A mainboard for a consumer electronic product, wherein the mainboard comprises:
at least two layers of printed circuit boards PCBs; and
electronic components disposed on each of the at least two layers of PCBs, wherein each layer of PCB constitutes a unit module that implements a function independently, wherein
the at least two layers of PCBs are stacked; and;
the at least two layers of PCBs are electrically connected.

2. The mainboard according to claim 1, wherein any two adjacent unit modules are connected by using a frame board.

3. The mainboard according to claim 2, wherein the frame board has a middle-hollow or partially hollow structure.

4. The mainboard according to claim 2 or 3, a cross-section of the frame board has a strip shape, an annular shape, a C-shape, a shape like the Chinese character " 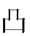 ", a shape like the Chinese character " 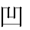 ", a shape like the Chinese character " 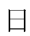 ", or a shape like the Chinese character " 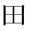 ".

5. The mainboard according to claim 2 or 3, wherein the frame board is connected to the PCBs by using bonding pads, to implement electric connection between the at least two layers of PCBs.

6. The stacked structure according to claim 5, wherein a metal dome is disposed on a surface of the bonding pad of the frame board.

7. The mainboard according to claim 2, 3 or 6, wherein screw holes are made into connecting interfaces of the frame board and the unit module.

8. The mainboard according to any one of claims 1 to 7, wherein the frame board is a PCB board.

9. The mainboard according to any one of claims 1 to 8, wherein each layer of PCB is a system in a package SIP module.

10. A terminal, wherein the terminal comprises the mainboard according to any one of claims 1 to 9.
